# EUROPÄISCHE PATENTSCHRIFT

(11) **EP 4 431 867 B1**
(45) Veröffentlichungstag und Bekanntmachung des Hinweises auf die Patenterteilung: **17.09.2025**
(21) Anmeldenummer: 24162346.1
(22) Anmeldetag: 08.03.2024
(51) Int. Cl.: G01B 11/06, G01B 11/30, H01L 21/66

(54) **VERFAHREN ZUM ERSTELLEN EINES SCHICHTDICKENVARIATIONSPROFILS EINER OBERFLÄCHENSCHICHT EINES SUBSTRATES**
METHOD FOR PRODUCING A LAYER THICKNESS VARIATION PROFILE OF A SURFACE LAYER OF A SUBSTRATE
PROCÉDÉ DE CRÉATION D'UN PROFIL DE VARIATION D'ÉPAISSEUR DE COUCHE D'UNE COUCHE SUPERFICIELLE D'UN SUBSTRAT

(30) Priorität: 17.03.2023 DE 102023106815
(43) Veröffentlichungstag der Anmeldung: 18.09.2024
(73) Patentinhaber: confovis GmbH, 07745 Jena (DE)
(72) Erfinder: Thielert, Frank, 07743 Jena (DE); Bergemann, Nico, 07743 Jena (DE)
(74) Vertreter: Steiniger, Carmen

(56) Entgegenhaltungen:
- WO-A1-2017/122248
- JP-A- 2010 117 161
- US-A1- 2019 228 515
- US-A1- 2022 252 507

## Beschreibung

Die vorliegende Erfindung betrifft ein Verfahren zum Erstellen eines Schichtdickenvariationsprofils einer Oberflächenschicht eines Substrates mit folgenden Schritten:
- Auswählen mehrerer Messfelder auf einer Substratoberfläche des Substrates;
   und
- Messen von Schichtdicken der Oberflächenschicht des Substrates an einer Vielzahl von Messstellen in den jeweiligen Messfeldern mit einem Messgerät.

Beim Nachbearbeiten eines Substrates, insbesondere beim Schleifen eines Siliziumwafers mit einer darauf aufgebrachten transparenten Schicht, wie beispielsweise einer LiTaO₃-Schicht, entstehen charakteristische Schleifmuster auf einer Oberflächenschicht des Substrates. Die Topographie dieser Schleifmuster, das heißt, die örtliche Variation einer Schichtdicke der jeweiligen Oberflächenschicht, hängt von den Prozessparametern der Nachbearbeitung ab. Die jeweilige Topographie spiegelt eine Welligkeit oder eine Rauheit der Oberflächenschicht des Substrates wider.

Für bestimmte Anwendungen, beispielsweise bei der Herstellung von Resonatoren, darf die Welligkeit der Oberflächenschicht des Substrates bestimmte Grenzwerte beim Peakto-Valley-Verhältnis, d. h. dem Abstand zwischen einer Senke und einer Spitze im Schichtdickenprofil der Oberflächenschicht, nicht überschreiten.

Um beurteilen zu können, welche Bereiche des Substrates für eine Weiterverarbeitung geeignet sind und welche Bereiche aufgrund einer zu starken Oberflächenvariation nicht für die Weiterverarbeitung taugen, ist es wichtig, ein möglichst vollständiges und genaues Bild von einem Schichtdickenvariationsprofil der Oberflächenschicht eines Substrates zu haben.

Zur Bestimmung des Schichtdickenvariationsprofils einer Oberflächenschicht lässt sich diese beispielsweise mit einem Rasterkraftmikroskop an mehreren Stellen untersuchen.

Dazu werden Messfelder auf einer Substratoberfläche ausgewählt und diese dann Linie für Linie abgetastet.

Statt eines Rasterkraftmikroskops können auch andere Messgeräte zur Ermittlung eines Schichtdickenvariationsprofils innerhalb der jeweiligen Messfelder verwendet werden.

Die mit den jeweiligen Messgeräten innerhalb der Messfelder jeweils ermittelten Schichtdickenvariationsprofile sind sehr genau, allerdings sind die anzustellenden Messungen sehr zeitaufwändig.

Ein weiteres Problem ergibt sich daraus, dass die Ermittlung eines Schichtdickenvariationsprofils auf einzelne, typischerweise nur wenige Quadratmillimeter große Messfelder der Substratoberfläche beschränkt ist. Die in den Messfeldern jeweils ermittelten Schichtdickenvariationsprofile stellen somit nur Stichproben dar und vermitteln ein nur unvollständiges Bild von einer Oberflächenstruktur des Substrates.

Die Druckschrift US 2018/0347966 A1 beschreibt ein Verfahren zum Messen von Dickenschwankungen in einer ersten Schicht einer mehrschichtigen Halbleiterstruktur. Gemäß diesem Verfahren wird mittels eines Messgerätes die Schichtdicke der ersten Schicht an unterschiedlichen Messstellen gemessen. Zudem wird mit einer Kamera eine Graubildaufnahme von der ersten Schicht aufgenommen, anhand der Graustufenwerte an den zuvor bestimmten Messstellen ermittelt werden. Die gemessenen Schichtdicken werden den entsprechenden Graustufenwerten zugeordnet, wobei eine theoretische Kurve erstellt werden kann, die auf der Abszisse die Graustufenwerte und auf der Ordinate die Schichtdicke der ersten Schicht umfasst. Diese Kurve kann dann zur Überprüfung weiterer Schichten, die den Produktspezifikationen entsprechen, verwendet werden. In der Druckschrift US 2019/0228515 A1 ist ein Verfahren zum Erkennen von Defekten eines Substrates beschrieben. Bei dem Verfahren wird ein Graustufenbild von dem zu analysierenden Substrat erstellt. Auf Basis von sich ergebenden Graustufendifferenzen in dem Graustufenbild, welche verschiedene Regionen des Substrates aufzeigen, werden Filmdickendifferenzwerte berechnet, die zur Beurteilung des Substrates herangezogen werden.

Aus den Druckschriften WO 2017/122248 A1 und JP 2010-117161 A sind Verfahren zur Schichtdickenmessung anhand von Graubildaufnahmen bekannt.

Davon ausgehend ist es die Aufgabe der vorliegenden Erfindung, ein Verfahren zur Verfügung zu stellen, das eine schnelle und zugleich zuverlässige Bewertung einer Oberflächenstruktur von Substratoberflächen ermöglicht.

Die Aufgabe wird durch ein Verfahren zum Erstellen eines Schichtdickenvariationsprofils einer Oberflächenschicht eines Substrates mit folgenden Schritten gelöst:
- Aufnehmen einer Graubildaufnahme von einer Substratoberfläche des Substrates mit einer Kamera;
- Auswählen mehrerer Messfelder auf der Substratoberfläche des Substrates, wobei das Auswählen der mehreren Messfelder aus Bereichen der Graubildaufnahme erfolgt;
- Ermitteln von Graustufenwertvariationen zwischen an den Messstellen der jeweiligen Messfelder jeweils vorliegenden Graustufenwerten der Graubildaufnahme;
- Messen von Schichtdicken der Oberflächenschicht des Substrates an einer Vielzahl von Messstellen in den jeweiligen Messfeldern mit einem Messgerät;
- Ermitteln von Schichtdickenvariationen durch Differenzbildung zwischen den an den Messstellen der jeweiligen Messfelder gemessenen Schichtdicken;
- Zuordnen der zwischen den Messstellen jeweils ermittelten Schichtdickenvariationen zu jeweils zwischen diesen Messstellen ermittelten Graustufenwertvariationen; und
- Erstellen des Schichtdickenvariationsprofils der Oberflächenschicht anhand der Graustufenwerte der Graubildaufnahme.

Zur Durchführung des erfindungsgemäßen Verfahrens wird zunächst eine Graubildaufnahme einer Substratoberfläche des Substrates mit einer Kamera aufgenommen. Die Graubildaufnahme stellt einen zusammenhängenden Bereich der Substratoberfläche sehr detailliert, das heißt, sehr hochaufgelöst, dar. Beispielsweise stellt die Graubildaufnahme ein Viertel eines beispielsweise scheibenförmigen Wafers dar. Jedem Bildpunkt bzw. Pixel der Graubildaufnahme wird ein Graustufenwert zwischen 0 und 255 zugeordnet.

Anhand der Graubildaufnahme werden geeignete Messfelder auf der Substratoberfläche identifiziert und ausgewählt. Geeignete Messfelder sind beispielsweise jene Messfelder, die einen großen Unterschied an Graustufenwerten aufweisen. Das Auswählen geeigneter Messfelder erfolgt beispielsweise durch einen Operator. Der Operator kann beim Auswählen geeigneter Messfelder durch eine Bilderkennungs- und/oder Bildauswertesoftware unterstützt werden. Es ist aber auch möglich, dass das Auswählen geeigneter Messfelder, beispielsweise mittels künstlicher Intelligenz, ausschließlich maschinell erfolgt.

In den anhand der Graubildaufnahme ermittelten Messfeldern wird anschließend mit einem Messgerät die Schichtdicke der Oberflächenschicht des Substrates an einer Vielzahl von Messstellen ermittelt. Dabei wird, je nach Aufgabenstellung, Verfügbarkeit, gewünschter Genauigkeit usw., das entsprechende Messgerät ausgewählt. Als Messgeräte eignen sich sämtliche im Bereich der Schichtdicken- und/oder Rauheitsmessung von Substratoberflächen gängigen Geräte, die beispielsweise auf einem berührenden, d. h. taktilen, Messverfahren beruhen, wie die Rasterkraftmikroskopie, oder die auf berührungslosen Verfahren, insbesondere auf optischen Messverfahren aus dem Bereich der Konfokaltechnik, beruhen.

Die Messfelder sind bei besonders hochauflösenden Messgeräten typischerweise nur wenige Quadratmillimeter groß, beispielsweise 3 mm x 3 mm. Entsprechend stellt eine Messung in dem jeweiligen Messfeld nur eine Stichprobe von der gesamten Substratoberfläche dar.

Anschließend an die Messung mit dem Messgerät werden durch Differenzbildung Schichtdickenvariationen zwischen den an den Messstellen der jeweiligen Messfelder gemessenen Schichtdicken ermittelt.

Dabei wird ein Schichtdickenprofil der Oberflächenschicht des Substrates in ein Schichtdickenvariationsprofil transformiert. Schließlich kommt es bei einer Charakterisierung der Welligkeit der Substratoberfläche nicht auf absolute Schichtdicken an. Je nachdem welches Messgerät verwendet wird, werden häufig bereits durch das angewandte Messverfahren direkt schon Schichtdickenvariationsprofile in den jeweiligen Messfeldern ermittelt. Im Ergebnis dieses Verfahrensschrittes sind für die jeweiligen Messfelder die dortigen Schichtdickenvariationsprofile hinlänglich, d. h. in ausreichender Genauigkeit, bekannt.

Die Messstellen in den Messfeldern werden dann einzelnen Bildpunkten, d. h. Pixeln, der Graubildaufnahme zugeordnet. Somit ist also jeder der Messstellen auch ein Graustufenwert, d. h. beispielsweise ein Wert zwischen 0 und 255, zugeordnet.

In einem weiteren Verfahrensschritt werden Graustufenwertvariationen zwischen den an den Messstellen der jeweiligen Messfelder jeweils vorliegenden Graustufenwerten der Graubildaufnahme ermittelt.

Zwischen den Messstellen der jeweiligen Messfelder werden also sowohl Schichtdickenvariationen als auch Graustufenwertvariationen ermittelt.

In einem weiteren Verfahrensschritt werden die zwischen den Messstellen jeweils ermittelten Schichtdickenvariationen zu den jeweils zwischen diesen Messstellen ermittelten Graustufenwertvariationen zugeordnet.

Infolgedessen lässt sich in einem weiteren Verfahrensschritt das Schichtdickenvariationsprofil der gesamten in der Graubildaufnahme aufgenommenen Oberflächenschicht anhand der Graustufenwerte der Graubildaufnahme ermitteln.

Damit lässt sich ausgehend von hochauflösenden Messungen der Schichtdickenvariation innerhalb der ausgewählten Messfelder auf das Schichtdickenvariationsprofil der gesamten in der Graubildaufnahme dargestellten Oberflächenschicht des Substrates schließen.

Das Verfahren liefert damit eine schnelle und zuverlässige Methode, um Substrate hinsichtlich ihrer Oberflächenrauheit zu charakterisieren und um beispielsweise festzustellen, welche Bereiche des Substrates für eine Weiterverarbeitung geeignet sind und welche aufgrund einer zu großen Oberflächenrauheit für eine Weiterverarbeitung nicht in Frage kommen.

Das erfindungsgemäße Verfahren lässt sich vorteilhaft dadurch weiterbilden, dass die zwischen den Messstellen jeweils ermittelten Schichtdickenvariationen zusammen mit den zwischen den jeweiligen Messstellen ermittelten Graustufenwertvariationen in einem Datensatz gespeichert werden, wenigstens eine weitere Graubildaufnahme von einer weiteren Substratoberfläche eines weiteren Substrates aufgenommen wird und der Datensatz angewendet wird, um das Schichtdickenvariationsprofil einer Oberflächenschicht des weiteren Substrates anhand von Graustufenwerten der weiteren Graubildaufnahme von der weiteren Substratoberfläche des weiteren Substrates zu erstellen.

Beispielsweise wird die Substratoberfläche eines ersten Substrates innerhalb der mehreren Messfelder untersucht, um so eine Zuordnung zwischen der Schichtdickenvariation und der zugehörigen Graustufenwertvariation zu gewinnen. Die Zuordnung wird in einem Datensatz gespeichert. Beispielsweise lässt sich die Zuordnung tabellarisch und/oder in Form einer Funktion in dem Datensatz speichern. Der Datensatz wird anschließend verwendet, um direkt die von einer weiteren Substratoberfläche eines weiteren Substrates aufgenommene Graubildaufnahme auszuwerten. Dies ermöglicht es, Substratoberflächen hinsichtlich ihrer Oberflächenrauheit genau zu charakterisieren, ohne dass eine Schichtdickenmessung mit einem entsprechenden Messgerät an dem weiteren Substrat vorgenommen werden muss.

Wenn die zwischen den Messstellen jeweils ermittelten Schichtdickenvariationen zusammen mit den zwischen den jeweiligen Messstellen ermittelten Graustufenwertvariationen in einem Datensatz gespeichert werden, erweist es sich als besonders vorteilhaft, wenn die in dem Datensatz enthaltenen Schichtdickenvariationen verschiedenen Schichtdickenvariationsbereichen zugeordnet werden und den einzelnen Schichtdickenvariationsbereichen jeweils wenigstens eine der Graustufenwertvariationen zugeordnet wird.

Die Zuordnung der Schichtdickenvariationen zu verschiedenen Schichtdickenvariationsbereichen kann beispielsweise in Form einer Schichtdickenvariationsskala erfolgen, die in Schichtdickenvariationsbereiche, d. h. in Intervalle, aufgeteilt ist.

Die Schichtdickenvariationsskala muss nicht unbedingt linear sein, d. h., sie muss nicht unbedingt in gleichgroße Intervalle unterteilt sein. Durch die Zuordnung der in dem Datensatz enthaltenen Schichtdickenvariationen zu einer diskreten Menge von Schichtdickenvariationsbereichen lässt sich eine einfachere Zuordnung der Schichtdickenvariationen zu den typischerweise ebenfalls nur diskrete Werte annehmenden Graustufenwertvariationen vornehmen.

Wenn die zwischen den Messstellen jeweils ermittelten Schichtdickenvariationen zusammen mit den zwischen den jeweiligen Messstellen ermittelten Graustufenwertvariationen in einem Datensatz gespeichert werden, lässt sich das erfindungsgemäße Verfahren besonders vorteilhaft weiterbilden, wenn mehrere der Datensätze, die an unterschiedlichen Substraten ermittelt wurden, in einem Datenpaket gespeichert und verknüpft werden, wobei das Datenpaket verwendet wird, um eine künstliche Intelligenz zu trainieren, welche das jeweilige Schichtdickenvariationsprofil nur aus den Graustufenwerten oder den Graustufenwertvariationen von an noch weiteren Substraten aufgenommenen Graubildaufnahmen erstellt.

Das erfindungsgemäße Verfahren lässt sich dadurch verbessern, dass bei dem Auswählen der mehreren Messfelder Bereiche in einer Substratmitte und/oder an einem Substratrand des Substrates nicht berücksichtigt werden. Diese Bereiche sind produktionsbedingt nicht aussagekräftig bzw. ohnehin nicht weiterverwendbar und können den Eindruck der Substratoberfläche verfälschen. Da zur Erzielung einer besonders hohen Qualität von mit dem erfindungsgemäßen Verfahren ermittelten Schichtdickenvariationsprofilen eine belastbare Korrelation zwischen den Graustufenwertvariationen und den Schichtdickenvariationen vorhanden sein muss, ist es daher von Vorteil, wenn Bereiche in der Substratmitte und/oder am Substratrand und/oder in ähnlich neuralgischen Bereichen der Substratoberfläche ausgespart bleiben.

Nach Ausschluss von Bereichen in der Substratmitte und/oder am Substratrand erweist es sich für das erfindungsgemäße Verfahren als besonders vorteilhaft, wenn die mehreren Messfelder so ausgewählt werden, dass in den Messfeldern stärkste Graustufen-Unterschiede im Vergleich zu anderen Bereichen der Substratoberfläche vorliegen. Stärkste Graustufen-Unterschiede bedeuten, dass bezogen auf einen Graustufenbereich von 0 bis 255 in der Graubildaufnahme Differenzen zwischen den Graustufenwerten wenigstens 10 Graustufen, vorzugsweise wenigstens 15 Graustufen, besonders bevorzugt wenigstens 20 Graustufen, betragen. Gleichzeitig weisen die Messfelder in Bereichen stärkster Graustufen-Unterschiede typischerweise auch größte Abstände zwischen Spitzen und Senken, also Peaks und Valleys, einer Substratoberfläche auf. Durch breite Ausschöpfung von Wertebereichen hinsichtlich der Schichtdickenvariation also auch hinsichtlich der korrespondierenden Graustufenwertvariation, sind die Bereiche stärkster Graustufen-Unterschiede besonders gut für eine Kalibrierung des erfindungsgemäßen Verfahrens geeignet.

Die Genauigkeit des erfindungsgemäßen Verfahrens lässt sich weiter dadurch steigern, dass die mehreren Messfelder so ausgewählt werden, dass sie sich partiell überlappen. Durch sich partiell überlappende Messfelder gehen keine Schichtdicken- bzw. Graustufenwertvariatonen in Randbereichen angrenzender, nicht überlappender Messfelder verloren. Ferner können auf diese Weise sprunghafte Variationen von einem Messfeld zu dem angrenzenden besser erkannt werden.

In einer besonders vorteilhaften Ausführungsform des erfindungsgemäßen Verfahrens ist die Oberflächenschicht transparent und das Messgerät ist ein optisches Messgerät.

Beispielsweise wird hierbei als Substrat ein Silizium-Substrat verwendet, das mit einer LiTaO₃-Schicht beschichtet ist. Die LiTaO₃-Schicht bildet eine transparente Oberflächenschicht des Substrates. Die Bestimmung der Schichtdicke dieser Oberflächenschicht erfolgt beispielsweise mit einem Interferometer, einem Reflektometer, einem Refraktometer oder einer Streulichtmethode.

Vorteilhafte Ausführungsformen des erfindungsgemäßen Verfahrens, dessen Durchführung und Vorteile werden nachfolgend anhand von Figuren näher erläutert. Dabei zeigen
- Figur 1: schematisch ein Substrat, von dem ein Schichtdickenvariationsprofil gemäß einer Ausführungsform des erfindungsgemäßen Verfahrens bestimmt wird, in einer Draufsicht;
- Figur 2: schematisch eine von einer Substratoberfläche des Substrates aus Figur 1 aufgenommene Graubildaufnahme;
- Figur 3: schematisch ein Schichtdickenprofil;
- Figur 4: schematisch ein Schichtdickenvariationsprofil zum Schichtdickenprofil aus Figur 3;
- Figur 5: schematisch ein Graustufenwertprofil;
- Figur 6: schematisch ein Graustufenwertvariationsprofil des Graustufenwertprofils aus Figur 5; und
- Figur 7: schematisch ein normalisiertes Graustufenvariationsprofil des Graustufenvariationsprofils aus Figur 6 verknüpft mit einem normalisierten Schichtdickenvariationsprofil des Schichtdickenvariationsprofils aus Figur 4.

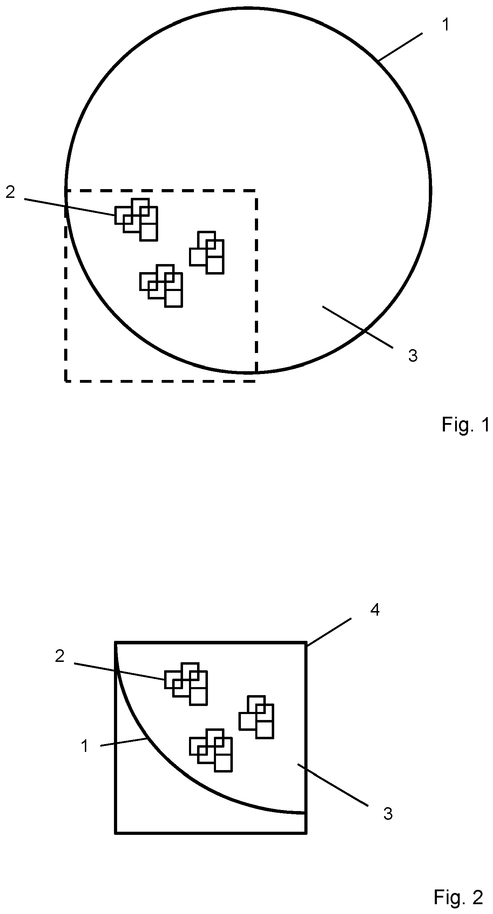

In Figur 1 ist ein Substrat 1 mit einer Oberflächenschicht in einer Draufsicht, d. h. mit Blick auf eine Substratoberfläche 3 des Substrates 1, gezeigt.

Bei dem in Figur 1 gezeigten Substrat 1 handelt es sich um ein scheibenförmiges Silizium-Substrat, auf dem die Oberflächenschicht durch eine transparente LiTaO₃-Schicht ausgebildet ist.

Ein Schleifen der LiTaO₃-Schicht bei einer Nachbearbeitung des Substrates 1 hat auf dessen Substratoberfläche 3 ein annähernd radialsymmetrisches Schleifmuster hinterlassen. Entsprechend variiert eine Schichtdicke der Oberflächenschicht.

Erfindungsgemäß gibt es nun mehrere Möglichkeiten, ein Schichtdickenvariationsprofil der Oberflächenschicht des Substrates 1 zu ermitteln. In jedem Fall wird eine Graubildaufnahme 4 der Substratoberfläche 3 oder zumindest eines Teils der Substratoberfläche 3 aufgenommen.

In Figur 1 ist der Teil der Substratoberfläche 3, von dem die Graubildaufnahme 4 aufgenommen wird, schematisch durch ein gestricheltes Rechteck gekennzeichnet. Die von diesem Teil der Substratoberfläche 3 aufgenommene Graubildaufnahme 4 ist in Figur 2 gesondert dargestellt.

Wie es in den Figuren 1 und 2 zu erkennen ist, ist in der Gaubildaufnahme 4 ungefähr ein Viertel der Substratoberfläche 3 des zu untersuchenden Substrates 1 aufgenommen. Je nach verwendeter Kamera und je nach Art und Form des zu untersuchenden Substrates 1 kann ein Bildausschnitt der Substratoberfläche 3 für eine Graubildaufnahme 4 auch anders ausgewählt sein und beispielsweise die gesamte Substratoberfläche 3 beinhalten.

Anhand der Graubildaufnahme 4 werden geeignete Messfelder 2 ausgewählt. Bei der Auswahl geeigneter Messfelder 2 werden vorliegend Bereiche an einem Substratrand und einer Substratmitte des Substrates 1 nicht berücksichtigt, da sie in der Regel wenig aussagekräftig sind.

Bei der Auswahl der Messfelder 2 werden zudem insbesondere jene Bereiche der Substratoberfläche 3 herangezogen, die stärkste Graustufenwert-Unterschiede aufweisen und zugleich eine repräsentative Stichprobe des Schichtdickenvariationsprofils erwarten lassen. Vorliegend wurden Bereiche in der Graubildaufnahme identifiziert, in denen die Graustufenwerte zwischen 174 und 186 lagen.

Ein weiteres Kriterium für die Auswahl geeigneter Messfelder 2 besteht darin, dass sich die ausgewählten Messfelder 2 gut mit einem Messgerät zur Bestimmung der Schichtdicke d vermessen lassen.

Vorliegend werden die Messfelder 2 durch einen menschlichen Operator ausgewählt. Der Operator kann bei seiner Auswahl geeigneter Messfelder auch durch eine Bilderkennungs- und/oder Bildauswertesoftware unterstützt werden. In einer weiteren Ausführungsform des erfindungsgemäßen Verfahrens erfolgt das Auswählen geeigneter Messfelder ausschließlich maschinell mittels künstlicher Intelligenz.

Wie es in den Figuren 1 und 2 gezeigt ist, überlappen sich die Messfelder 2 partiell und bilden somit ein Cluster, das einen größeren zusammenhängenden Bereich der Substratoberfläche 3 lückenlos bedeckt.

Die Messfelder 2 weisen eine Vielzahl von Messstellen auf, deren Position auf der Substratoberfläche 3 vorliegend durch Koordinaten x, y eines kartesischen Koordinatensystems angegeben ist. Die Position der Messtellen lässt sich auch durch ein anderes Koordinatensystem, z. B. ein Polarkoordinatensystem, erfassen und angeben.

Innerhalb der Messfelder 2 werden nun an den einzelnen Messstellen Schichtdicken d mit einem Messgerät gemessen. Vorliegend wird die Schichtdicke d der transparenten Oberflächenschicht des Substrates 1 mit einem Reflektometer gemessen.

Die an den Messtellen gemessenen Schichtdicken d liefern zumindest für den Bereich der Substratoberfläche 3, in dem sich das entsprechende Messfeld 2 befindet, ein hochaufgelöstes und hinreichend genaues Schichtdickenprofil der Oberflächenschicht.

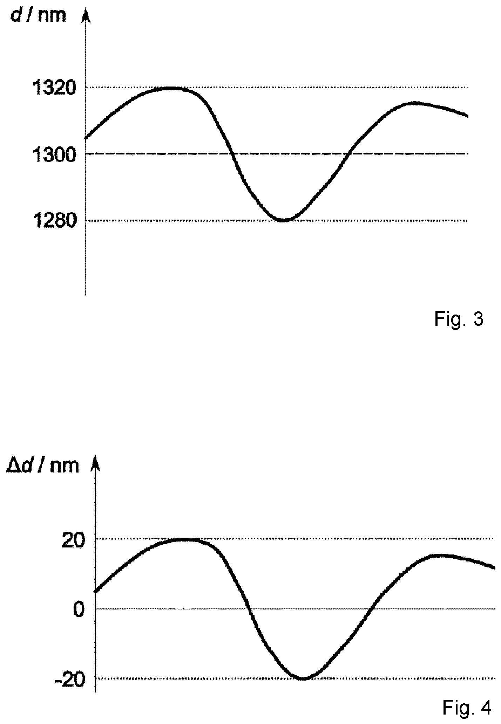

Ein solches Schichtdickenprofil ist in Figur 3 schematisch dargestellt. Das in Figur 3 gezeigte Diagramm stellt die gemessene Schichtdicke d der Oberflächenschicht in Nanometern in Abhängigkeit von einem Ort der Messstelle dar.

Aus dem Schichtdickenprofil wird durch Differenzbildung ein Schichtdickenvariationsprofil ermittelt, welches schematisch in Figur 4 dargestellt ist.

Je nachdem welches Messgerät verwendet wird, werden von diesem unter Umständen bereits selbst Schichtdickenvariationsprofile ermittelt. In diesem Fall erfolgt also entweder direkt schon beim Messen eine Umrechnung von Schichtdicken d in Schichtdickenvariationen oder eine zugrunde liegende Messmethode liefert von vornherein ausschließlich Schichtdickendifferenzen, d. h. Schichtdickenvariationen, anstatt absoluter Schichtdicken. Dies gilt beispielsweise für taktile Messsysteme zur Bestimmung von Oberflächenrauheiten.

Da die Messfelder 2 auch in der Graubildaufnahme 4 enthalten sind, d. h. jene Bereiche auf der Substratoberfläche 4, in denen ein Schichtdickenvariationsprofil gemessen oder ermittelt wurde, auch in der Graubildaufnahme 4 zu sehen sind, ist jeder der Messstellen auch ein Graustufenwert g zwischen 0 und 255 zuordenbar.

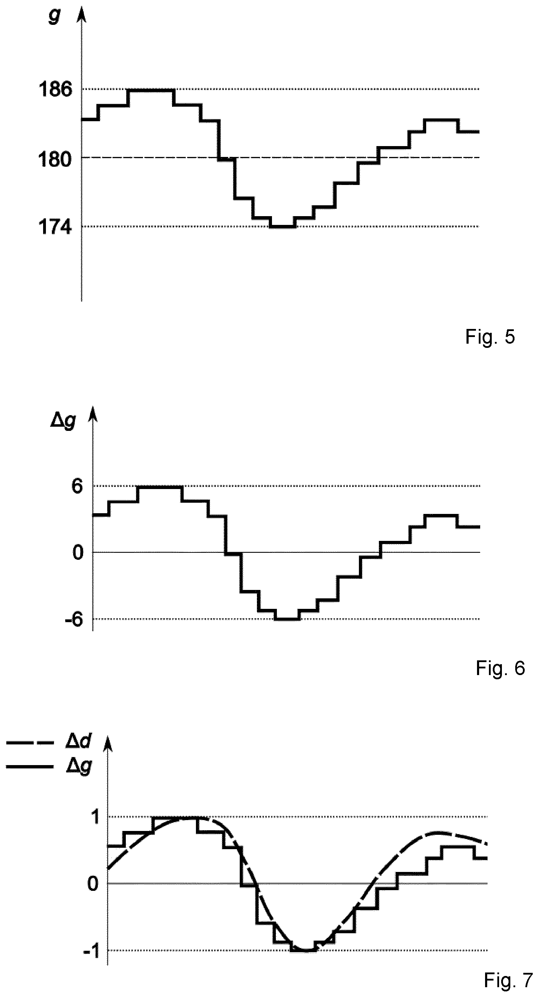

Die ortsabhängigen Graustufenwerte g lassen sich als ein Graustufenwertprofil der Oberflächenschicht des Substrates 1 erfassen, wie es schematisch in Figur 5 dargestellt ist.

In einem weiteren Schritt des erfindungsgemäßen Verfahrens werden aus den von zwischen an den Messstellen der jeweiligen Messfelder 2 jeweils vorliegenden Graustufenwerten g der Graubildaufnahme 4 Graustufenwertvariationen ermittelt. Dies liefert für die Messfelder 2 ein zusätzliches Graustufenwertvariationsprofil, wie es schematisch in Figur 6 gezeigt ist.

Damit ist es möglich, die zwischen den Messstellen jeweils ermittelten Schichtdickenvariationen zu jeweils zwischen diesen Messstellen ermittelten Graustufenwertvariationen zuzuordnen, wie es in Figur 7 verdeutlicht ist.

In dem in Figur 7 gezeigten Diagramm sind die aus Messungen mit dem Messgerät hervorgegangenen Schichtdickenvariationsprofile, gemeinsam mit dem zugehörigen, aus der Graubildaufnahme 4 ermittelten Graustufenwertvariationsprofil dargestellt, wobei Werte des Schichtdickenvariationsprofils und des Graustufenwertvariationsprofils normalisiert sind.

Mit dieser Zuordnung ist es möglich, ein Schichtdickenvariationsprofil der gesamten, in der Graubildaufnahme 4 aufgenommenen Substratoberfläche 3 des Substrates 1 zu erstellen, welches im Folgenden als erstes Substrat 1 bezeichnet wird.

Vorliegend werden die zwischen den Messstellen jeweils ermittelten Schichtdickenvariationen zusammen mit den zwischen den jeweiligen Messstellen ermittelten Graustufenwertvariationen in einem Datensatz gespeichert.

Mit Hilfe dieses Datensatzes lässt sich ein Schichtdickenvariationsprofil einer Oberflächenschicht eines weiteren Substrates ermitteln. Das weitere Substrat ist grundsätzlich wie das erste Substrat 1 aufgebaut, kann aber andere Oberflächeneigenschaften, insbesondere eine andere Oberflächenrauheit aufweisen. Von der Substratoberfläche des weiteren Substrates wird eine weitere Graubildaufnahme aufgenommen und der Datensatz, der auf Basis des ersten Substrates 1 erstellt wurde, auf diese angewandt.

Genauso lässt sich der Datensatz auf Graubildaufnahmen 4 anderer Bereiche der in Figur 1 gezeigten Substratoberfläche 3 anwenden. So lässt sich bei dem in Figur 1 dargestellten Beispiel mit drei weiteren Graubildaufnahmen 4 die restliche Substratoberfläche 3 aufnehmen und durch Anwendung des Datensatzes ein vollständiges Schichtdickenvariationsprofil der gesamten Substratoberfläche 3 ermitteln.

Vorliegend werden zudem mehrere der Datensätze, die an unterschiedlichen Substraten ermittelt wurden, in einem Datenpaket gespeichert und verknüpft. Das ständig wachsende Datenpaket wird verwendet, um eine künstliche Intelligenz zu trainieren, welche das jeweilige Schichtdickenvariationsprofil nur aus den Graustufenwerten g von an noch weiteren Substraten aufgenommenen Graubildaufnahmen erstellt. Das heißt, nach einem Anlernen der künstlichen Intelligenz, kann diese allein auf Basis von Graubilddaten eine umfassende Charakterisierung einer Topographie der Oberflächenschicht, im vorliegenden Fall also der transparenten LiTaO₃-Schicht, vornehmen. Durch zusätzliche Referenzdaten und einer vorzugsweise stetig wachsenden Datenbasis, wird eine Genauigkeit und Reproduzierbarkeit des erfindungsgemäßen Verfahrens fortlaufend erhöht.

Die anhand der Figuren 1 bis 7 nur beispielhaft beschriebenen Möglichkeiten zur Durchführung des erfindungsgemäßen Verfahrens lassen sich miteinander in vielfältiger Weise kombinieren. Gleiches gilt für einzelne Verfahrensschritte und deren Reihenfolge. Auch lässt sich das erfindungsgemäße Verfahren auf eine Vielzahl von unterschiedlichen Substratoberflächen und Oberflächenschichten anwenden.

In weiteren Ausführungsformen des erfindungsgemäßen Verfahrens werden Bilddaten der Graubildaufnahmen und/oder mit dem Messgerät ermittelte Messdaten vor einer Auswertung mit einem Bandpass-Filter gefiltert, um Rauschen und makroskopische Variationen zu unterdrücken.

Auch kann es von Vorteil sein, für jedes Messfeld eine Hauptkomponentenanalyse durchzuführen, um eine Dimensionalität von 2D auf 1D zu reduzieren.

Zudem kann das erfindungsgemäße Verfahren durch einen zusätzlichen Kalibrierschritt auch zur Ermittlung einer absoluten Schichtdicke einer Oberflächenschicht eines Substrates verwendet werden. Dazu wird beispielsweise durch ausgewählte Messungen mit einem Reflektometer oder einem anderen gängigen Messgerät zu Bestimmung von Schichtdicken eine Korrelation zwischen Graustufenwerten und absoluten Schichtdicken der Oberflächenschicht hergestellt.

In einer weiteren Ausführungsform des erfindungsgemäßen Verfahrens werden Messungen mit dem Reflektometer zur Bestimmung der Schichtdicke durch Messungen mit weiteren Messgeräten validiert. Beispielsweise werden die Messungen mit dem vorliegend verwendeten Reflektometer mittels Konfokalmikroskopie validiert.

## Patentansprüche

1. Verfahren zum Erstellen eines Schichtdickenvariationsprofils einer Oberflächenschicht eines Substrates (1) mit folgenden Schritten:
- Auswählen mehrerer Messfelder (2) auf einer Substratoberfläche (3) des Substrates (1);
- Messen von Schichtdicken (d) der Oberflächenschicht des Substrates (1) an einer Vielzahl von Messstellen in den jeweiligen Messfeldern (2) mit einem Messgerät;
- Aufnehmen einer Graubildaufnahme (4) von der Substratoberfläche (3) des Substrates (1) mit einer Kamera, wobei das Auswählen der mehreren Messfelder (2) aus Bereichen der Graubildaufnahme (4) erfolgt;
- Ermitteln von Graustufenwertvariationen zwischen an den Messstellen der jeweiligen Messfelder (2) jeweils vorliegenden Graustufenwerten (g) der Graubildaufnahme (4);
- Ermitteln von Schichtdickenvariationen durch Differenzbildung zwischen den an den Messstellen der jeweiligen Messfelder (2) gemessenen Schichtdicken;
- Zuordnen der zwischen den Messstellen jeweils ermittelten Schichtdickenvariationen zu jeweils zwischen diesen Messstellen ermittelten Graustufenwertvariationen; und
- Erstellen des Schichtdickenvariationsprofils der Oberflächenschicht anhand der Graustufenwerte (g) der Graubildaufnahme (4).

2. Verfahren nach Anspruch 1, **dadurch gekennzeichnet, dass** die zwischen den Messstellen jeweils ermittelten Schichtdickenvariationen zusammen mit den zwischen den jeweiligen Messstellen ermittelten Graustufenwertvariationen in einem Datensatz gespeichert werden, wenigstens eine weitere Graubildaufnahme von einer weiteren Substratoberfläche eines weiteren Substrates aufgenommen wird und der Datensatz angewendet wird, um das Schichtdickenvariationsprofil einer Oberflächenschicht des weiteren Substrates anhand von Graustufenwerten (g) der weiteren Graubildaufnahme von der weiteren Substratoberfläche des weiteren Substrates zu erstellen.

3. Verfahren nach Anspruch 2, **dadurch gekennzeichnet, dass** die in dem Datensatz enthaltenen Schichtdickenvariationen verschiedenen Schichtdickenvariationsbereichen zugeordnet werden und den einzelnen Schichtdickenvariationsbereichen jeweils wenigstens eine der Graustufenwertvariationen zugeordnet wird.

4. Verfahren nach Anspruch 2 oder 3, **dadurch gekennzeichnet, dass** mehrere der Datensätze, die an unterschiedlichen Substraten ermittelt wurden, in einem Datenpaket gespeichert und verknüpft werden, wobei das Datenpaket verwendet wird, um eine künstliche Intelligenz zu trainieren, welche das jeweilige Schichtdickenvariationsprofil nur aus den Graustufenwerten (g) oder den Graustufenwertvariationen von an noch weiteren Substraten aufgenommenen Graubildaufnahmen erstellt.

5. Verfahren nach einem der vorhergehenden Ansprüche, **dadurch gekennzeichnet, dass** bei dem Auswählen der mehreren Messfelder (2) Bereiche in einer Substratmitte und/oder an einem Substratrand des Substrates (1) nicht berücksichtigt werden.

6. Verfahren nach Anspruch 5, **dadurch gekennzeichnet, dass** die mehreren Messfelder (2) so ausgewählt werden, dass in den Messfeldern (2) stärkste Graustufen-Kontraste im Vergleich zu anderen Bereichen der Substratoberfläche (3) vorliegen.

7. Verfahren nach einem der vorhergehenden Ansprüche, **dadurch gekennzeichnet, dass** die mehreren Messfelder (2) so ausgewählt werden, dass sie sich partiell überlappen.

8. Verfahren nach einem der vorhergehenden Ansprüche, **dadurch gekennzeichnet, dass** die Oberflächenschicht transparent ist und das Messgerät ein optisches Messgerät ist.

## Claims

1. Method for creating a layer thickness variation profile of a surface layer of a substrate (1), comprising the following steps:
- selecting a plurality of measurement fields (2) on a substrate surface (3) of the substrate (1);
- measuring layer thicknesses (d) of the surface layer of the substrate (1) with a measuring device at a plurality of measuring points in the respective measurement fields (2);
- capturing a grayscale image (4) of the substrate surface (3) of the substrate (1) with a camera, wherein the plurality of measurement fields (2) is selected from regions of the grayscale image (4);
- determining grayscale value variations between the grayscale values (g) present at the measuring points of the measurement fields (2) of the grayscale image (4);
- determining layer thickness variations by difference calculation between the layer thicknesses measured at the measuring points of the measurement fields (2);
- assigning the layer thickness variations determined between the measuring points to the corresponding grayscale value variations determined between these measuring points; and
- creating the layer thickness variation profile of the surface layer on the basis of the grayscale values (g) of the grayscale image (4).

2. Method according to claim 1, **characterized in that** the layer thickness variations determined between the measuring points, together with the grayscale value variations determined between the respective measuring points, are stored in a data set, at least one further grayscale image is captured of a further substrate surface of a further substrate, and the data set is utilized to create the layer thickness variation profile of a surface layer of the further substrate on the basis of grayscale values (g) of the further grayscale image of the further substrate surface of the further substrate.

3. Method according to claim 2, **characterized in that** the layer thickness variations contained in the data set are assigned to different layer thickness variation ranges, and the individual layer thickness variation ranges are assigned to at least one of the grayscale value variations, respectively.

4. Method according to claim 2 or 3, **characterized in that** a plurality of the data sets which have been determined for different substrates are stored and linked in a data package, wherein the data package is used to train an artificial intelligence which creates the respective layer thickness variation profile solely from the grayscale values (g) or the grayscale value variations of grayscale images captured from yet further substrates.

5. Method according to one of the preceding claims, **characterized in that,** when the plurality of measurement fields (2) is selected, regions in a substrate center and/or on a substrate edge of the substrate (1) are not taken into account.

6. Method according to claim 5, **characterized in that** the plurality of measurement fields (2) is selected such that the grayscale contrasts are the highest in the measurement fields (2) in comparison with other regions of the substrate surface (3).

7. Method according to one of the preceding claims, **characterized in that** the plurality of measurement fields (2) is selected such that the measurement fields (2) partially overlap.

8. Method according to any of the preceding claims, **characterized in that** the surface layer is transparent, and the measuring device is an optical measuring device.

## Revendications

1. Procédé de création d'un profil de variation d'épaisseur de couche d'une couche superficielle d'un substrat (1) comprenant les étapes suivantes:
- sélectionner une pluralité de champs de mesure (2) sur une surface de substrat (3) du substrat (1);
- mesurer des épaisseurs de couche (d) de la couche superficielle du substrat (1) en une pluralité de points de mesure dans les champs de mesure (2) respectifs avec un dispositif de mesure;
- prendre une image en niveaux de gris (4) de la surface du substrat (3) du substrat (1) avec une caméra, la sélection de la pluralité de champs de mesure (2) s'effectuant à partir de zones de l'image en niveaux de gris (4);
- déterminer des variations de valeurs de niveaux de gris entre des valeurs de niveaux de gris (g) présentes aux points de mesure des champs de mesure (2) respectifs de l'image en niveaux de gris (4);
- déterminer des variations d'épaisseur de couche en calculant les différences entre les épaisseurs de couche mesurées aux points de mesure des champs de mesure (2) respectifs;
- attribuer les variations d'épaisseur de couche déterminées entre les points de mesure aux variations de valeur de niveaux de gris déterminées entre ces points de mesure; et
- créer le profil de variation d'épaisseur de couche de la couche superficielle en fonction des valeurs de niveaux de gris (g) de l'image en niveaux de gris (4).

2. Procédé selon la revendication 1, **caractérisé en ce que** les variations d'épaisseur de couche déterminées entre les points de mesure avec les variations de valeurs de niveaux de gris déterminées entre les points de mesure respectifs sont enregistrées dans un ensemble de données, au moins une autre image en niveaux de gris est prise à partir d'une autre surface de substrat d'un autre substrat, et l'ensemble de données est utilisé pour créer le profil de variation d'épaisseur de couche d'une couche superficielle de l'autre substrat sur la base des valeurs de niveaux de gris (g) de l'autre image en niveaux de gris à partir de l'autre surface de substrat de l'autre substrat.

3. Procédé selon la revendication 2, **caractérisé en ce que** les variations d'épaisseur de couche contenues dans l'ensemble de données sont attribuées à différentes plages de variation d'épaisseur de couche et au moins une des variations de valeur de niveaux de gris est attribuée aux plages de variation d'épaisseur de couche individuelles.

4. Procédé selon la revendication 2 ou 3, **caractérisé en ce que** plusieurs des ensembles de données qui ont été déterminés sur différents substrats sont sauvegardés et liés dans un paquet de données, le paquet de données étant utilisé pour former une intelligence artificielle qui crée le profil de variation d'épaisseur de couche respectif uniquement à partir des valeurs de niveaux de gris (g) ou des variations de valeurs de niveaux de gris d'images en niveaux de gris prises sur encore d'autres substrats.

5. Procédé selon l'une des revendications précédentes, **caractérisé en ce que** lors de la sélection de la pluralité de champs de mesure (2), des zones dans un centre de substrat et/ou sur un bord de substrat du substrat (1) ne sont pas prises en compte.

6. Procédé selon la revendication 5, **caractérisé en ce que** la pluralité de champs de mesure (2) est sélectionnée de telle sorte que les contrastes de niveaux de gris les plus forts soient présents dans les champs de mesure (2) par rapport à d'autres zones de la surface du substrat (3).

7. Procédé selon l'une des revendications précédentes, **caractérisé en ce que** la pluralité de champs de mesure (2) est sélectionnée de telle sorte qu'ils se chevauchent partiellement.

8. Procédé selon l'une des revendications précédentes, **caractérisé en ce que** la couche superficielle est transparente et le dispositif de mesure est un dispositif de mesure optique.
